# EUROPÄISCHE PATENTSCHRIFT

(11) **EP 1 495 497 B1**
(45) Veröffentlichungstag und Bekanntmachung des Hinweises auf die Patenterteilung: **29.10.2008**
(21) Anmeldenummer: 03722394.8
(22) Anmeldetag: 03.04.2003
(51) Int. Cl.: H01L 31/115

(54) **ORTSEMPFINDLICHE GERMANIUMDETEKTOREN MIT MIKROSTRUKTUR AUF BEIDEN KONTAKTFLÄCHEN**
POSITION-SENSITIVE GERMANIUM DETECTORS HAVING A MICROSTRUCTURE ON BOTH CONTACT SURFACES
DETECTEURS AU GERMANIUM SENSIBLES A LA POSITION COMPORTANT UNE MICROSTRUCTURE SUR LES DEUX FACES DE CONTACT

(30) Priorität: 18.04.2002 DE 10217426
(43) Veröffentlichungstag der Anmeldung: 12.01.2005
(73) Patentinhaber: Forschungszentrum Jülich GmbH, 52425 Jülich (DE)
(72) Erfinder: PROTIC, Davor, 52428 Jülich (DE); KRINGS, Thomas, 52441 Linnich (DE)
(74) Vertreter: Gille Hrabal Struck Neidlein Prop Roos
(86) Internationale Anmeldenummer: PCT/EP2003/003485
(87) Internationale Veröffentlichungsnummer: WO 2003/088368

(56) Entgegenhaltungen:
- US-A- 5 164 809
- US-B1- 6 175 120
- BECKER H ET AL: "NEW DEVELOPMENTS IN DOUBLE SIDED SILICON STRIP DETECTORS" IEEE TRANSACTIONS ON NUCLEAR SCIENCE, IEEE INC. NEW YORK, US, Bd. 37, Nr. 2, 1. April 1990 (1990-04-01), Seiten 101-106, XP000142784 ISSN: 0018-9499
- HOLL P ET AL: "A DOUBLE-SIDED SILICON STRIP DETECTOR WITH CAPACITIVE READOUT AND A NEW METHOD OF INTEGRATED BIAS COUPLING" IEEE TRANSACTIONS ON NUCLEAR SCIENCE, IEEE INC. NEW YORK, US, Bd. 36, Nr. 1 - 1, 1. Februar 1989 (1989-02-01), Seiten 251-255, XP000250117 ISSN: 0018-9499
- BECKER H ET AL: "READOUT OF DOUBLESIDED SILICON STRIP DETECTORS WITH HIGH DENSITY INTEGRATED ELECTRONICS" IEEE TRANSACTIONS ON NUCLEAR SCIENCE, IEEE INC. NEW YORK, US, Bd. 36, Nr. 1, 1. Februar 1989 (1989-02-01), Seiten 246-250, XP000253827 ISSN: 0018-9499

## Beschreibung

Die Erfindung betrifft einen ortsauflösenden Detektor für die Messung von geladenen Teilchen oder Photonen. Ferner betrifft die Erfindung einen Tomographen oder eine Compton-Kamera mit einem derartigen Detektor.

Ein Detektor der eingangs genannten Art ist der Druckschrift "High Purity Germanium Position-Sensitive Detector for Positron Annihilation Experiments", G. Riepe, D. Protl'c, R. Kurz, W. Triftshäuser, Zs. Kajcsos and J. Winter, Proceedings 5th Int. Conf. Positron Annihilation, (Japan, 1979) zu entnehmen. Hieraus ist ein aus sehr reinem kristallinen Germanium bestehender Detektor bekannt, der beidseitig mit Mikrostrukturen versehen worden ist. Auf einer Seite des Detektors wurde Phosphor und auf der anderen Seite Bor implantiert. Die Implantation erfolgte durch Ionenimplantation.

Gelangt ein geladenes Teilchen oder Photon In den Detektor, so erzeugt es im Bereich des kristallinen Germaniums Elektron-Loch-Paare. Die jeweilige Ladung wandert zum entsprechenden Kontakt und wird hier ausgelesen. Die ortsabhängig gemessene Ladung stellt ein Maß für die gesuchte Information dar.

Insbesondere mit Bor dotierte Kontakte können durch Ionenimplantation sehr einfach hergestellt werden.

Mit Phosphor zu implantieren, ist grundsätzlich ebenfalls ein technisch sehr einfaches Verfahren. Nachteilhaft treten jedoch Strahlenschäden auf, die zu p⁺-Dotierung in einer Schicht führen, die eigentlich einen n- oder n⁺-Kontakt darstellen soll. Entsprechend störend wirken sich die Strahlenschäden aus.

Zur Lösung des Problems der Strahlenschäden wird versucht, den Detektor zu tempern. Dies erfolgt bei Temperaturen von typischerweise 350 bis 400°C. Durch den Temperschritt werden Strahlenschäden minimiert, so dass nach erfolgreicher Durchführung ein guter n- oder n⁺-Kontakt in der betreffenden Schicht erreicht wird.

Nachteilhaft weist ein Kristall an der Oberfläche regelmäßig Verunreinigungen, insbesondere aufgrund von vorliegendem Kupfer auf. Kupfer diffundiert bei den für das Tempern erforderliche Temperaturen typischerweise sehr schnell in den Kristall hinein. Häufig führt dies zu solchen Störeffekten, dass der Detektor insgesamt unbrauchbar wird. Das sehr teure Material kann nicht wieder verwendet werden. Das Herstellungsverfahren ist aufgrund der hohen Ausfallquote sehr teuer.

Um zu einem ortsauflösenden Detektor zu gelangen, werden die n- bzw. p-Schichten mit Strukturen versehen. Die Strukturen können durch ein lithographisches Verfahren erzeugt werden. Lithographische Verfahren gehören zum allgemeinen Fachwissen. Ein lichtempfindlicher Lack wird bei einem photophotolithografischen Verfahren auf die Oberfläche aufgetragen, die strukturiert werden soll. Durch eine Maske hindurch wird der lichtempfindliche Lack teilweise belichtet. Mittels Plasmaätzen werden anschließend Gräben in die Oberfläche an den belichteten Stellen des Photolacks eingebracht. Die n-Schicht bzw. p-Schicht liegt dann strukturiert vor. Hierunter ist zu verstehen, dass die als n- oder p-Kontakt wirkende Schicht in einzelne Segmente unterteilt ist, die durch Gräben voneinander getrennt sind. Diese getrennten Elemente werden In der Literatur vielfach als Ortselemente bezeichnet. Abschließend kann die Lackschicht zum Beispiel durch chemisches Ätzen entfernt werden.

Die Strukturierung kann beidseitig streifenförmig erfolgen. Die Streifen auf der einen Seite sind dann zum Beispiel senkrecht relativ zu den Streifen auf der anderen Seite ausgerichtet, Im Prinzip sind jedoch beliebige geometrische Muster möglich. So wurde bereits eine spiralförmige Strukturierung zu beiden Seiten vorgesehen. Die Spiralen verliefen entgegengesetzt, so dass ebenfalls eine Ortsauflösung möglich war.

Weitere Beispiele für mögliche Strukturierungen finden sich in der Druckschrift "Nuclear Instruments & Methods in Phiysics research, Section A, A 421 (1999) 447-457, M. Betigeri et al.".

Die bekannten Strukturen können auch bei der Erfindung vorgesehen sein.

Um die problematische Phosphorschicht zu vermeiden, ist bereits versucht worden, Phosphor durch Lithium zu ersetzen. Nachteilhaft sind mit Lithium jedoch nicht so feine Strukturen wie beim Phosphor möglich. Ursache hierfür ist, dass Lithium sehr tief In den Kristall einbringt. Lithographische Verfahren einschließlich Plasmaätzen können nicht mehr angewendet werden, da die erforderlichen Tiefen nicht erreicht werden. Es ist daher erforderlich, die Lithiumschicht durch Sägen zu strukturieren. Diese Technik ermöglicht jedoch nicht so feine Auflösungen, wie sie durch lithographische Verfahren erreicht werden können. Es lassen sich also mit einem Detektor, der auf einer Seite mit Lithium dotiert ist, keine sehr großen Ortsauflösungen erzielen.

Aufgrund der Dicke der Lithiumschicht, die typischerweise 200 bis 1000 µm tief ist, lassen sich ferner nachteilhaft keine Transmissionsdetektoren bereitstellen.

Um eine Phosphorschicht und die damit verbundenen Nachteile zu vermeiden und dennoch zu hohen Ortsauflösungen einschließlich eines Transmissionsdetektors zu gelangen, ist versucht worden, die Phosphorschicht durch eine amorphe Germaniumschicht zu ersetzen, die mit einer Aluminiumoberflächenschicht versehen worden ist. Ein solcher Stand der Technik ist beispielsweise aus der Druckschrift "A 140-element Germanium Detector Fabricated with Amorphous Germanium Blocking Contacts"P.N. Luke et al, IEEE Transactions on Nuclear Science, Vol, 41, No. 4, August 1994" bekannt. Das Dokument US-B-6,175,120 beschreibt einen Detektor für die Messung von geladenen Teilchen.

Aluminium kann durch andere Metalle wie Palladium oder Gold ersetzt sein.

Um beim vorgenannten Stand der Technik zur gewünschten Strukturierung zu gelangen, wird das Metall strukturiert und zwar streifenförmig aufgetragen. Beim Stand der Technik wird die amorphe Germaniumschicht nicht strukturiert. Diese ist nur sehr gering leitfähig, so dass die Strukturierung der metallischen Oberfläche genügt, um einen ortsauflösenden Detektor zu erhalten.

Versuche haben jedoch gezeigt, dass beim vorgenannten Detektor mit der strukturierten metallischen Oberfläche nur eine vergleichsweise schlechte Energieauflösung erreicht wird. Ferner treten bei der Energiebestimmung relativ viele Messfehler auf.

Aufgabe der Erfindung ist die Schaffung eines Detektors der eingangs genannten Art mit einer verbesserten Genauigkeit bei der Energiebestimmung und einer verbesserten Energieauflösung bei der Messeung.

Die Aufgabe der Erfindung wird durch einen ortsauflösenden Detektor mit den Merkmalen des ersten Anspruchs gelöst. Vorteilhafte Ausgestaltungen ergeben sich aus den Unteransprüchen. Ein Verfahren zur Herstellung des Detektors ergibt sich aus dem nebengeordneten Anspruch.

Die Struktur der metallischen Schicht ist in die amorphe Schicht hinein fortgesetzt. Es kommt also erfindungsgemäß darauf an, dass nicht nur die metallische Oberfläche, sondern auch die darunter befindliche amorphe Schicht strukturiert ist. Die Strukturen stimmen überein.

Vorteilhaft reicht die Struktur der metallischen Schicht durch die amorphe Schicht hindurch bis in die Kristallstruktur hinein, auf der die amorphe Schicht aufgebracht ist.

Es hat sich gezeigt, dass die Messgenauigkeit bei der Energiebestimmung im Vergleich zum Stand der Technik erhöht wird, wenn die Strukturierung In die amorphe Schicht hineinreicht. Auch wird die erreichbare Energieauflösung deutlich verbessert. Die Verbesserungen gelingen Insbesondere, wenn die Struktur durch die amorphe Schicht hindurchgeführt ist und bis in die darunter befindliche kristalline Struktur hineinreicht. Es genügen einige µm Tiefe der Struktur im kristallinen Bereich. Wenigstens 1 µm tief, bevorzugt wenigstens 5 µm tief sollte die Struktur In den halbleitenden Bereich hineinreichen.

Sehr gute Ergebnisse wurden mit einer amorphen Schicht aus Germanium erzielt. Die metallische Schicht kann zum Beispiel aus Aluminium, Palladium oder Gold bestehen. Der kristalline Bereich unterhalb der amorphen Schicht besteht bevorzugt dann ebenfalls aus Germanium.

Um zu guten Ortsauflösungen zu gelangen, wird die Struktur durch Segmente gebildet, die untereinander einen Abstand von weniger als 200 µm, insbesondere einen Abstand von weniger als 100 µm, besonders bevorzugt von weniger als 20 µm aufweisen. Die praktisch realisierbare Untergrenze liegt bei ca. 1 µm. Die gewünschten kleinen Strukturen können beispielsweise durch ein photophotolfithografisches Verfahren erzeugt werden.

Die amorphe Schicht ist grundsätzlich auf einem Halbleitermaterial aufgebracht. Die amorphe Schicht weist daher eine elektrische Leitfähigkeit auf, die wesentlich kleiner als die Leitfähigkeit des Material ist, welches sich unterhalb der amorphen Schicht befindet.

Erfindungsgemäß wird In einem Ausführungsbeispiel zur Herstellung zunächst eine amorphe Germaniumschicht auf kristallines Germanium aufgesputtert oder aufgedampft. Anschließend wird eine Metallschicht so z.B. eine Aluminiumschicht aufgedampft. Anschließend werden lithographisch die gewünschten Strukturen definiert hergestellt. Innerhalb der amorphen Germanium-Metall-Schicht werden Gräben so tief geätzt, dass diese wenigstens bis an den Germaniumkristallbereich herangelangen. Vorteilhaft reichen diese Gräben bis in den Germaniumkristall hinein.
Auf der gegenüberliegenden Seite wurde durch Dotierung mit Bor und anschließender Mikrostrukturierung der Gegenkontakt (p⁺) bereitgestellt.

Beim Ausführungsbeispiel konnten die folgenden Vorteile festgestellt werden:
- Eine Einzelauslese von unter 100 µm breiten Segmenten ist möglich;
- eine Ortsauflösung von besser als 100 µm x 100 µm kann realisiert werden;
- ein Betrieb bei hohen Zählraten oberhalb von 10⁵ Ereignissen pro Sekunde ist möglich;
- eine schnelle Ortsbestimmung (typischerweise 20 ns für Germanium) für Triggerzwecke und zur Auflösung von Mehrdeutigkeiten ist durchführbar;
- es gelingt der Nachweis von zwei oder mehr gleichzeitig einfallenden Teilchen oder Photonen;
- Eine dreldimensionale Ortsbestimmung (Δz ∼ 100 µm) durch individuelle Driffizeitmessungen pro Segment mit Zeitauflösungen <10 ns FWHM kann durchgeführt werden;
- eine Teilchenidentifikation durch Messung der Driftzeitdifferenzen ist durchführbar.

Die Maße eines Detektors betragen typischerweise 3 Zoll im Durchmesser. Die Dicke des Detektors beträgt typischerweise 10 bis 20 mm. Die effektive Dicke der Borschicht liegt regelmäßig unterhalb von 1 µm. Die Dicke der amorphen Germaniumschicht ist typischerweise ca. 0,1 µm dick. Die Metallschicht ist typischerweise 0,1 bis 0,2 µm dick. Die Tiefe der Gräben beträgt typischerweise 10 µm.

Beim Stand der Technik reicht implantiertes Bor regelmäßig bis zu 10 µm oder sogar bis zu 20 µm In den Germaniumkristall hinein. Bis in diese Tiefe wurde auch geätzt. Im vorliegenden Fall unterscheidet sich die Erfindung vom Stand der Technik Insbesondere dadurch, dass die Tiefe des Grabens sehr viel weiter reicht, als dies für die Metallschicht oder aber auch für die amorphe Germaniumschicht an für sich hätte erforderlich sein müssen. Dies ist erfindungswesentlich, um die optimalen Wirkungen zu erzielen.

Anstelle eines Germaniumkristalls kann ein aus Silizium bestehender Kristall vorgesehen werden.

Der Detektor ist insbesondere im medizinischen Bereich einzusetzen, da die bisher verwendeten Detektoren nicht die erforderlichen Ortsauflösungen bei gleichzeitiger hoher Zählrate liefern. Die Ortsauflösung kann bei der vorliegenden Erfindung praktisch unbegrenzt gesteigert werden. Größenordnungsmäßlg kann die Ortsauflösung im Vergleich zu bisher bei in der Medizin eingesetzten Detektoren unter Beibehaltung der übrigen Leistungsfähigkeit ohne weiteres verdoppelt werden. Die Ortsauflösung im medizinischen Bereich betrug bisher 2 mm. Ortsauflösungen von 1 mm können nun unproblematisch realisiert werden. Insbesondere im Bereich der Tomographie wird der Detektor eingesetzt, um zu wesentlich besseren Ergebnissen zu gelangen.

Positronen-Emmisionstomographie ist ein weiteres an Gebiet im medizinischen Bereich, wo der Detektor vorteilhaft eingesetzt werden kann. SPECT ist ein weiteres Anwendungsbeispiel. Der Detektor ist dann insbesondere Bestandteil einer Compton-Kamera. Kleintierpositronen-Emmisionstomographie ist ein weiteres typisches Anwendungsbeispiel in der Medizin.

Ein weitere wichtiges Anwendungsgebiet ist die Astrophysik für den vorliegenden Detektor.

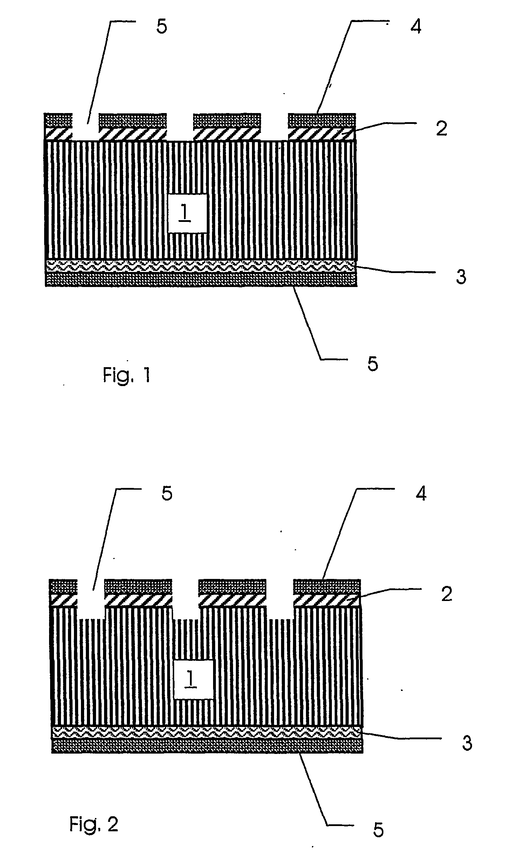

Anhand der Figuren 1 und 2 werden Ausführungsbeispiele der Erfindung näher erläutert.

Figur 1 zeigt einen Schnitt durch einen aus Germanium bestehenden Halbleiter 1. Der Halbleiter 1 weist an einer Oberfläche ein Schicht 2 auf, die aus amorphen Germanium besteht. Diese bildet einen n⁺-Kontakt. Entgegengesetzt befindet sich eine Schicht 3 des Halbleiters, die mit Bor dotiert ist. Diese bildet einen p⁺-Kontakt. Auf den Schichten 2 und 3 sind metallische Schichten 4 und 5 aufgebracht, die der elektrischen Kontaktierung dienen.

Im Unterschied zum Stand der Technik ist auf der Seite mit dem n⁺-Kontakt nicht lediglich die metallische Schicht strelfenförmig strukturiert. Statt dessen reichen die Gräben 5 bis In die amorphe Schicht 2 hinein, so dass diese einzelne voneinander getrennte Segmente aufweist.

Auf der entgegengesetzten Seite kann der p⁺-Kontakt ebenfalls strelfenförmig strukturiert sein. Die Streifen verlaufen dann grundsätzlich senkrecht zu den Streifen auf der Seite mit dem amorphen Germanium, (hier also parallel zur Papierebene). Daher sind keine Gräben sichtbar.

Besonders leistungsfähig ist die Ausführungsform gemäß Figur 2. Hier reichen die Gräben 5 bis in das Halbleitermaterial hinein.

Anstelle von Germanium kann beispielsweise kristallines bzw, amorphes Silizium eingesetzt sein. Als Halbleitermaterial kommen III-V-Verbindungen wie GaAs oder CdTe in Betracht. Anstelle einer Dotierung mit Bor wurde festgestellt, dass die Schicht 3 durch amorphes Germanium oder aber auch amorphes Silizium ersetzt sein kann. Warum dies funktioniert, ist physikalisch nicht geklärt.

Die Breite der Gräben liegen zwischen 1 und 200 µm. Die Streifen sind also 1 und 200 µm voneinander entfernt.

## Patentansprüche

1. Ortsauflösender Detektor für die Messung von geladenen Teilchen oder Photonen mit einem Oberflöchenbereich, der durch eine amorphe Schicht (2) und eine darüber befindliche, strukturierte metallische Schicht (4) gebildet ist, mit einem kristallinen Bereich (1) unterhalb der amorphen Schicht,
**dadurch gekennzeichnet, dass**
die Struktur (5) der metallischen Schicht in die amorphe Schicht (2) hinein fortgesetzt ist, so daß die Struktur (5) in der amorphen Schicht (2) mit der Struktur (5) in der metallischen Schicht übereinstimmt.

2. Ortsauflösender Detektor nach Anspruch 1, **dadurch gekennzeichnet, dass** die Struktur der metallischen Schicht durch die amorphe Schicht hindurch bis In die Kristallstruktur hineinreicht, auf der die amorphe Schicht aufgebracht ist.

3. Ortsauflösender Detektor nach Anspruch 1 oder 2, **dadurch gekennzeichnet, dass** die amorphe Schicht aus Germanium oder Silizium gebildet ist.

4. Ortsauflösender Detektor nach einem der vorhergehenden Ansprüche, **dadurch gekennzeichnet, dass** die metallische Schicht aus Aluminium, Palladium oder Gold besteht.

5. Ortsauflösender Detektor nach einem der vorhergehenden Ansprüche, **dadurch gekennzeichnet, dass** der kristalline Bereich unterhalb der amorphen Schicht aus Germanium, Silizium oder einer III-V-Verbindung gebildet ist.

6. Ortsauflösender Detektor nach einem der vorhergehenden Ansprüche, **dadurch gekennzeichnet, dass** die Struktur durch Segmente gebildet ist, die untereinander einen Abstand von weniger als 200 µm, insbesondere einen Abstand von weniger als 100 µm, besonders bevorzugt von weniger als 20 µm aufweisen.

7. Ortsauflösender Detektor nach einem der vorhergehenden Ansprüche, **dadurch gekennzeichnet, dass** die amorphe Schicht auf einem Halbleitermaterial aufgebracht ist.

8. Ortsauflösender Detektor nach einem der vorhergehenden Ansprüche, **dadurch gekennzeichnet, dass** die amorphe Schicht eine elektrische Leitfähigkeit aufweist, die wesentlich kleiner als die Leitfähigkeit des Materials ist, welches sich unterhalb der amorphen Schicht befindet.

9. Tomograph oder Compton-Kamera mit einem Detektor nach einem der vorhergehenden Ansprüche.

## Claims

1. Spatially resolving detector for measuring charged particles or photons, having a surface area formed by an amorphous layer (2) and a structured metallic layer (4) located thereabove, with a crystalline area (1) underneath the amorphous layer, **characterised in that** the structure (5) of the metallic layer is continued into the amorphous layer so that the structure (5) in the amorphous layer (2) matches the structure (5) in the metallic layer.

2. Spatially resolving detector according to claim 1, **characterised in that** the structure of the metallic layer extends through the amorphous layer into the crystal structure on which the amorphous layer is applied.

3. Spatially resolving detector according to claim 1 or 2, **characterised in that** the amorphous layer is formed of germanium or silicon.

4. Spatially resolving detector according to one of the preceding claims, **characterised in that** the metallic layer comprises aluminium, palladium or gold.

5. Spatially resolving detector according to one of the preceding claims, **characterised in that** the crystalline area underneath the amorphous layer is formed of germanium, silicon or a III-V-compound.

6. Spatially resolving detector according to one of the preceding claims, **characterised in that** the structure is formed by segments having a distance from one other of less than 200 µm, in particular a distance of less than 100 µm, particularly preferably of less than 20 µm,

7. Spatially resolving detector according to one of the preceding claims, **characterised in that** the amorphous layer is applied on a semiconductor material.

8. Spatially resolving detector according to one of the preceding claims, **characterised in that** the amorphous layer has an electrical conductivity which is considerably smaller than the conductivity of the material located underneath the amorphous layer.

9. Tomograph or Compton camera comprising a detector according to one of the preceding claims.

## Revendications

1. Détecteur sensible à la position pour la mesure de particules chargées ou de photons avec une zone superficielle qui est formée par une couche amorphe (2) et une couche métallique (4), structurée se trouvant dessus, avec une zone cristalline (1) au-dessous de la couche amorphe, **caractérisé en ce que** la structure (5) de la couche métallique est poursuivie dans la couche amorphe (2) de sorte que la structure (5) dans la couche amorphe (2) concorde avec la structure (5) dans la couche métallique.

2. Détecteur sensible à la position selon la revendication 1, **caractérisé en ce que** la structure de la couche métallique parvient au travers de la couche amorphe jusque dans la structure cristalline, sur laquelle est appliquée la couche amorphe.

3. Détecteur sensible à la position selon la revendication 1 ou 2, **caractérisé en ce que** la couche amorphe est constituée de germanium ou de silicium.

4. Détecteur sensible à la position selon l'une quelconque des revendications précédentes, **caractérisé en ce que** la couche métallique se compose d'aluminium, de palladium ou d'or.

5. Détecteur sensible à la position selon l'une quelconque des revendications précédentes, **caractérisé en ce que** la zone cristalline au-dessous de la couche amorphe est constituée de germanium, de silicium ou d'une combinaison III-V.

6. Détecteur sensible à la position selon l'une quelconque des revendications précédentes, **caractérisé en ce que** la structure est constituée de segments qui présentent entre eux une distance inférieure à 200 µm, en particulier une distance inférieure à 100 µm, de manière particulièrement préférée inférieure à 20 µm.

7. Détecteur sensible à la position selon l'une quelconque des revendications précédentes, **caractérisé en ce que** la couche amorphe est appliquée sur un matériau semi-conducteur.

8. Détecteur sensible à la position selon l'une quelconque des revendications précédentes, **caractérisé en ce que** la couche amorphe présente une conductibilité électrique qui est essentiellement inférieure à la conductibilité du matériau qui se trouve au-dessous de la couche amorphe.

9. Tomographe ou caméra Compton dotée d'un détecteur selon l'une quelconque des revendications précédentes.
